# EUROPÄISCHE PATENTSCHRIFT

(11) **EP 1 323 219 B1**
(45) Veröffentlichungstag und Bekanntmachung des Hinweises auf die Patenterteilung: **24.11.2004**
(21) Anmeldenummer: 01980186.9
(22) Anmeldetag: 20.09.2001
(51) Int. Cl.: H01S 5/20

(54) **HALBLEITER-LASER**
SEMICONDUCTOR LASER
LASER A SEMI-CONDUCTEUR

(30) Priorität: 20.09.2000 DE 10046580
(43) Veröffentlichungstag der Anmeldung: 02.07.2003
(73) Patentinhaber: Osram Opto Semiconductors GmbH, 93049 Regensburg (DE)
(72) Erfinder: ERBERT, Götz, 12555 Berlin (DE); TRÄNKLE, Günther, 12557 Berlin (DE); WENZEL, Hans, 12355 Berlin (DE)
(74) Vertreter: Epping Hermann & Fischer
(86) Internationale Anmeldenummer: PCT/DE2001/003649
(87) Internationale Veröffentlichungsnummer: WO 2002/025787

(56) Entgegenhaltungen:
- US-A- 5 260 959
- SMOWTON P M ET AL: "650-NM LASERS WITH NARROW FAR-FIELD DIVERGENCE WITH INTEGRATED OPTICAL MODE EXPANSION LAYERS" IEEE JOURNAL OF SELECTED TOPICS IN QUANTUM ELECTRONICS, IEEE SERVICE CENTER, US, Bd. 5, Nr. 3, Mai 1999 (1999-05), Seiten 735-739, XP000930556 ISSN: 1077-260X
- SHUN TUNG YEN ET AL: "THEORETICAL INVESTIGATION ON SEMICONDUCTOR LASERS WITH PASSIVE WAVEGUIDES" IEEE JOURNAL OF QUANTUM ELECTRONICS, IEEE INC. NEW YORK, US, Bd. 32, Nr. 1, 1996, Seiten 4-13, XP000548674 ISSN: 0018-9197
- LI W L ET AL: "Design of AlGaInP visible lasers with a low vertical divergence angle" SOLID STATE ELECTRONICS, ELSEVIER SCIENCE PUBLISHERS, BARKING, GB, Bd. 42, Nr. 1, 1998, Seiten 87-90, XP004108423 ISSN: 0038-1101
- MAWST L J ET AL: "DESIGN OPTIMIZATION OF ARROW-TYPE DIODE LASERS" IEEE PHOTONICS TECHNOLOGY LETTERS, IEEE INC. NEW YORK, US, Bd. 4, Nr. 11, 1. November 1992 (1992-11-01), Seiten 1204-1206, XP000328564 ISSN: 1041-1135
- PATENT ABSTRACTS OF JAPAN vol. 010, no. 359 (E-460), 3. Dezember 1986 (1986-12-03) -& JP 61 156788 A (SONY CORP), 16. Juli 1986 (1986-07-16)
- WENZEL ET AL.: "High-power diode lasers with small vertical beam divergence emitting at 808 nm" ELECTRONICS LETTERS, Bd. 37, Nr. 16, 2. August 2001 (2001-08-02), Seiten 1024-1026, XP006017047

## Beschreibung

Die Erfindung betrifft einen Halbleiter-Laser mit reduzierter vertikaler Strahldivergenz.

Halbleiter-Laser mit hoher optischer Ausgangsleistung werden für zahlreiche Anwendungen gebraucht. Derartige Anwendungen sind beispielsweise in der optischen Nachrichtentechnik, bei der Krebsbehandlung in der Medizin, beim optischen Pumpen von Festkörper-Lasern und bei der unmittelbaren Materialbearbeitung zu finden. Für diese Anwendung sind Halbleiter-Laser wegen ihrer geringen Größe, ihrem großen Wirkungsgrad, der Möglichkeit der elektrischen Ansteuerung und der Möglichkeit der preiswerten Fertigung in großen Stückzahlen besonders geeignet.

Insbesondere dienen Halbleiter-Laser mit der Emissionswellenlänge von 808 nm zum Pumpen von Nd:YAG-Festkörperlasern.

Halbleiter-Laser sind im allgemeinen Halbleiterbauelemente, bei denen auf einem Substrat mindestens eine aktive Schicht und je zwei innere und zwei äußere Begrenzungsschichten abgeschieden werden, wobei die aktive Schicht zwischen den beiden inneren Begrenzungsschichten angeordnet ist. Die Abscheidung der Schichten erfolgt üblicherweise mit Flüssigphasen-Epitaxie (LBE), metallorganischer Gasphasen-Epitaxie (MOCVD) oder Molekularstrahl-Epitaxie (MBE). Die Begrenzungsschichten sind von gegensätzlichem Leitungstyp, so daß beim Anlegen einer geeigneten elektrischen Spannung Löcher aus den p-leitenden Begrenzungsschichten und Elektronen aus den n-leitenden Begrenzungsschichten in die aktive Schicht injiziert werden und dort rekombinieren. Die Stirnflächen oder Kristallfacetten des Halbleiter-Lasers bilden einen Resonator. Oberhalb eines bestimmten elektrischen Stroms, des sogenannten Schwellenstroms, findet stimulierte Emission statt, und es wird ein nahezu monochromatischer gebündelter Lichtstrahl erzeugt, welcher aus einer halbdurchläßig gehaltenen Kristallfacette austritt.

Die äußeren Begrenzungsschichten haben üblicherweise eine geringere Brechzahl als die inneren Begrenzungsschichten und die aktive Schicht, so daß ein optischer Wellenleiter gebildet wird, wobei die inneren Begrenzungsschichten zusammen mit der aktiven Schicht den Wellenleiterkern bilden. Durch die Führung des Lichts im Wellenleiterkern soll eine möglichst große Überlappung des Lichtfeldes mit der aktiven Schicht erreicht werden. Üblicherweise wird der Wellenleiter so konstruiert, daß nur die sogenannte Grundmode und keine höheren Moden im Wellenleiterkern geführt werden. In diesem Zusammenhang wird unter Grundmode die Mode verstanden, deren einziges Intensitätsmaximum sich in der aktiven Schicht befindet. Höhere Moden sind dadurch ausgezeichnet, daß sie mehrere Intensitätsmaxima besitzen.

Unter anderem wird die optische Ausgangsleistung von Halbleiter-Lasern durch die thermisch bedingte Degradation der als Resonatorspiegel dienenden Kristallfacetten beschränkt. Um eine möglichst hohe optische Ausgangsleistung zu erzielen, muß dementsprechend die thermische Belastung der Kristallfacetten des Halbleiter-Lasers möglichst klein gehalten werden. Es besteht daher ein Interesse, den Strahlquerschnitt an den Kristallfacetten möglichst groß zu halten.

Aus der US 5,272,711 A ist bekannt, oberhalb der aktiven Schicht einen antiresonant reflektierenden Wellenleiter vorzusehen. Der antiresonant reflektierende Wellenleiter weist einen von Reflexionsbereichen seitlich begrenzten Wellenleiterkern, wobei sich an die Reflexionsbereiche Wellenleiteraußenbereiche anschließen. Im Querschnitt gesehen liegen der Wellenleiterkern, die Reflexionsbereiche und die Wellenleiteraußenbereiche in einer Schicht nebeneinander. Der Wellenleiterkern und die Wellenleiteraußenbereiche weisen jeweils geringere Brechungsindizes als die Reflexionsbereiche auf. Die Breite der Reflexionsbereiche entspricht einem ungeradzahligen Vielfachen eines Viertels der auf den Querschnitt projizierten Wellenlänge des Lichts. Die Breite der Wellenleiteraußenbereiche entspricht einem ungeradzahligen Vielfachen der halben Breite des Wellenleiterkerns. Im antiresonant reflektierenden Wellenleiter weist die Grundmode lediglich im Wellenleiterkern hohe Amplituden auf, während Moden höherer Ordnung auch in den Wellenleiteraußenbereichen hohe Amplituden aufweisen. Dadurch werden die Moden höherer Ordnung wirksam gedämpft. Mit einer derartigen Anordnung lassen sich Halbleiterlaser mit einem Wellenleiterkern mit einer Breite zwischen 4 bis 8 µm erzeugen. Die Divergenz des mit dem bekannten Halbleiter-Laser erzeugten Laserstrahls liegt im Bereich von 4° bis 8° in seitlicher Richtung.

Prinzipiell ähnliche Anordnungen sind in C. Zmudzinski et al., IEEE Journal of Selected Topics in Quantum Electronics, Vol. 1, No. 2, June 1995, 129 - 137, und in T. L. Koch et al., Applied Physics Letters 50 (6) 9 February 1987, 307 - 309, beschrieben.

Ein Nachteil des bekannten Halbleiter-Lasers ist die nach wie vor sehr hohe Divergenz in vertikaler Richtung von 30° bis 40°. Unter vertikaler Richtung wird dabei die Aufwachsrichtung der epitaktisch aufgebrachten Schichten verstanden. Durch die hohe Halbwertsbreite von 30° bis 40° können auch sehr aufwendige optische Vorrichtungen nur 80 % bis 90 % des vom Halbleiter-Laser emittierten Lichts nutzen.

Aus dem Artikel von D. Botez "Design considerations and analytical approximations for high continuous-wave power, broadwaveguide diode laser", Applied Physics Letters, Band 74, Seite 3102 - 3104, 1999, ist bekannt, daß die Strahldivergenz durch eine Verbreiterung des Wellenleiterkerns und durch die Verringerung der Differenz der Brechzahlen zwischen dem Wellenleiterkern und den angrenzenden Reflexionsschichten verringert werden kann. Die Aufweitung des Wellenleiterkerns hat jedoch zur Folge, daß durch den Wellenleiterkern nicht nur die Grundmoden, sondern zusätzlich auch höhere Moden geführt werden und unter Umständen die Laserschwelle erreichen können. Damit verbunden ist eine drastische Verschlechterung der Qualität des Laserstrahls. Die Dicke des Wellenleiterkerns ist daher in der Praxis auf Werte <2 µm beschränkt. Dies entspricht einer Strahldivergenz in vertikale Richtung von mehr als 30° Halbwertsbreite. Auch die Verringerung der Brechzahldifferenz zwischen dem Wellenleiterkern und den Reflexionsschichten ist in der Praxis nur schwer durchführbar. Um auf eine Strahldivergenz mit einer Halbwertsbreite <20° zu kommen, ist ein sehr hoher technologischer Aufwand für die Einstellung der sehr kleinen Brechzahldifferenz notwendig.

Weitere Ansätze zur Reduzierung der Strahldivergenz eines Halbleiterlasers sind in US 5,289,484, in US 5,815,521 sowie in Heonsu Jeon et al., IEEE Journal of Selected Topics in Quantum Electronics, Vol. 3, No. 6, Dec. 1997, 1344 - 1350, beschrieben.

Ausgehend von diesem Stand der Technik liegt der Erfindung die Aufgabe zugrunde, einen einfach herstellbaren einmodigen Halbleiter-Laser mit geringer vertikaler Strahldivergenz anzugeben.

Diese Aufgabe wird durch ein strahlungsemittierendes Halbleiterbauelement mit den Merkmalen des Patentanspruches 1 gelöst. Bevorzugte Ausführungsformen und Weiterbildungen des Bauelements sind Gegenstand der abhängigen Patentansprüche 2 bis 25.

Erfindungsgemäß ist vorgesehen, daß die Wellenleiteraußenbereiche, die Reflexionsbereiche und der Wellenleiterkern von einer auf ein Substrat aufgebrachten Schichtfolge mit in den Wellenleiterkern eingebetteter aktiver Schicht gebildet sind.

Zur weiteren Erhöhung der optischen Ausgangsleistung und zur Verbesserung der Strahlqualität wird bei dem Halbleiter-Laser gemäß der Erfindung die Schichtfolge so gewählt, daß ein antiresonant reflektierender Wellenleiter in vertikaler Richtung gebildet wird. Der Wellenleiterkern, die Reflexionsbereiche und die äußeren Wellenleiterbereiche werden erfindungsgemäß jeweils von Schichten gebildet. Dadurch kann der Wellenleiterkern eine Dicke von mehr als 2 µm aufweisen. Dadurch kann die vertikale Strahldivergenz wesentlich verringert werden. Insbesondere ein Wellenleiterkern mit einer Dicke von 3 µm weist im Wellenlängenbereich um 800 nm eine vertikale Strahldivergenz von etwa 18° volle Halbwertsbreite auf.

Außerdem wird durch die große Dicke des Wellenleiterkerns die optische Leistung über einen größeren Querschnitt verteilt, so daß die thermische Belastung der Kristallfacetten sinkt und eine höhere optische Ausgangsleistung erzielt werden kann.

Bei dem Halbleiter-Laser gemäß der Erfindung sind die Brechzahldifferenzen zwischen den einzelnen Schichten so hoch, daß große Fertigungstoleranzen möglich sind. Weiterhin ist dadurch, daß der Wellenleiterkern eine geringe Brechzahl besitzt, also in der Regel aus einem Halbleitermaterial mit größerer Energielücke besteht, ein besserer Einschluß der Ladungsträger gegeben und die Absorption durch Erwärmung an den Kristallfacetten verringert.

Bevorzugt umfaßt die aktive Schicht zwei sogenannte Spacer-Schichten, zwischen denen ein aktiver Quantentrog angeordnet ist. Die Spacer-Schichten führen zu einer Verbesserung der Grenzflächen des Quantentrogs und damit der Lasereigenschaften.

Besonders bevorzugt sind die Reflexionsschichten der erfindungsgemäßen Anordnungen hoch dotiert (z.B. 2x10¹⁸cm⁻³). Dieser Maßnahme liegt für sich alleine schon eine erfinderische Tätigkeit zugrunde, die unabhängig von den übrigen strukturellen Maßnahmen alleine bereits zu verbesserten Leistungsdaten führt.

Zur Reduzierung des Bahnwiderstandes können die Heterogrenzen der erfindungsgemäßen Strukturen gradiert sein (graded Heterojunctions).

Weitere Vorteile und vorteilhafte Ausführungsformen ergeben sich aus den im Folgenden in Verbindung mit den Figuren beschriebenen Ausführungsbeispielen. Es zeigen:
- Figur 1: eine schematische Darstellung eines Querschnitts durch eine Schichtfolge eines Halbleiter-Lasers gemäß der Erfindung;
- Figur 2: eine schematische Darstellung eines Diagramms, das den Verlauf der Brechzahl durch die Schichtenfolge zeigt;
- Figur 3: eine schematische Darstellung eines Diagramms mit dem Verlauf der optischen Intensität der Grundmode, wobei der Verlauf der Brechzahl unterlegt ist;
- Figur 4: eine schematische Darstellung eines Diagramms mit dem Verlauf der Fernfeldintensität des vom Halbleiter-Laser emittierten Laserstrahls;
- Figur 5: eine schematische Darstellung eines Diagramms mit dem Verlauf der optischen Intensität einer Mode höherer Ordnung, wobei der Verlauf der Brechzahl unterlegt ist; und
- Figur 6: eine schematische Darstellung eines Querschnitts durch eine weitere Schichtfolge eines HalbleiterLasers gemäß der Erfindung.

In den Beschreibungen der verschiedenen Ausführungsbeispiele sind gleiche oder gleichwirkende Bestandteile jeweils mit den gleichen Bezugszeichen versehen.

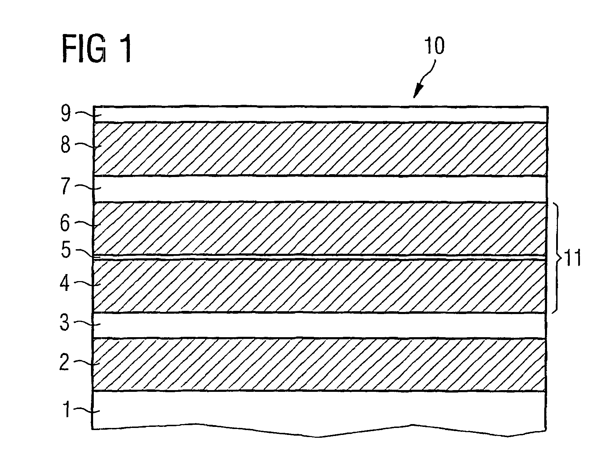

Figur 1 zeigt einen Querschnitt durch einen Halbleiter-Laser, der ein Substrat 1 mit einer Brechzahl n₁ aus einkristallinem Halbleitermaterial aufweist. Auf dem Substrat 1 befindet sich eine erste äußere Wellenleiterschicht 2 mit einer Brechzahl n₂ und der Dicke d₂. Der äußeren Wellenleiterschicht 2 ist eine erste Reflexionsschicht 3 mit einer Brechzahl n₃ und der Dicke d₃ nachgeordnet. Daran schließt sich eine innere Wellenleiterschicht 4 mit einer Brechzahl n₄ und der Dicke d₄, eine Photonen emittierende, aktive Schicht 5 mit der Brechzahl n₅ und der Dicke d₅ und eine zweite innere Wellenleiterschicht 6 an. Im weiteren folgen eine zweite Reflexionsschicht 7 mit dem Brechungsindex n₇ und der Dicke d₇, eine zweite äußere Wellenleiterschicht 8 mit der Brechzahl n₈ und der Dicke d₈ sowie eine Kontaktschicht 9 mit der Brechzahl n₉. Zusammen bilden die Schichten einen antiresonanten Wellenleiter 10, in dessen von den inneren Wellenleiterschichten 4 und 6 gebildeten Wellenleiterkern 11 die aktive Schicht 5 eingebettet ist.

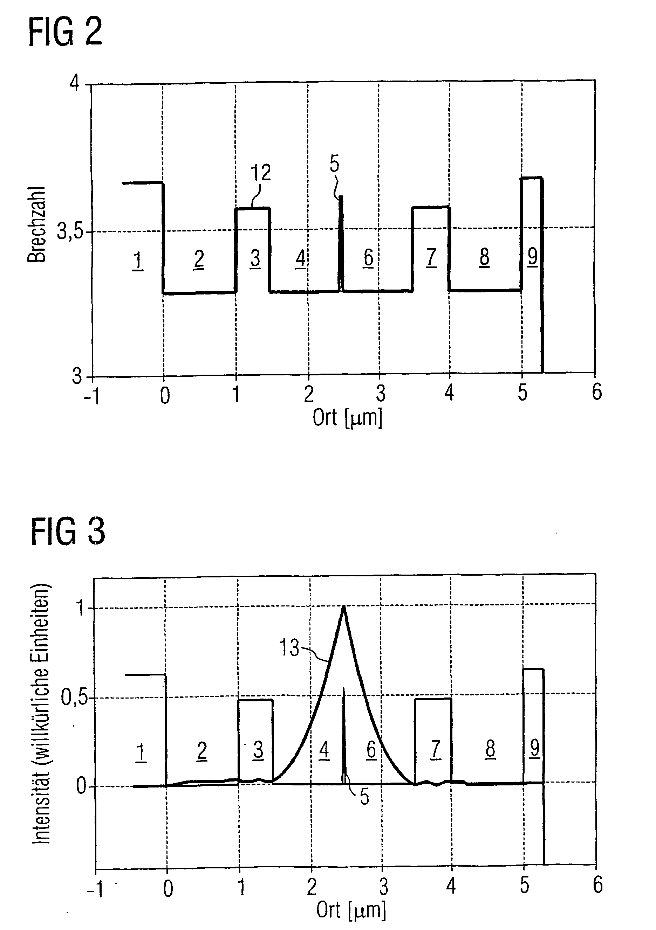

In Figur 2 ist ein möglicher Verlauf eines Brechzahlenprofils 12 dargestellt. In der Praxis braucht der Übergang von zwei Brechzahlenniveaus durchaus nicht sprunghaft zu erfolgen, sondern kann einen rampenförmigen, kontinuierlichen Verlauf aufweisen. Wesentlich für die Funktion des antiresonant reflektierenden Wellenleiters 11 ist, daß die Brechzahlen n₃ und n₇ der Reflexionsschichten 3 und 7 größer als die Brechzahlen n₂ und n₈ der äußeren Wellenleiterschichten 2 und 8 sowie der Brechzahlen n₄ und n₆ der inneren Wellenleiterschichten 4 und 6 sind. Dabei können die Brechzahlen der äußeren Begrenzungsschichten 2 und 8, der Reflexionsschichten 3 und 7 sowie der inneren Wellenleiterschichten 4 und 6 jeweils gleich sein. Das gleiche kann auch für die jeweiligen Schichtdicken gelten, so daß eine nahezu symmetrische Schichtfolge bezüglich der aktiven Schicht 5 entsteht.

Weiterhin können auch die Brechzahlen n₂ und n₄ der ersten äußeren und inneren Wellenleiterschicht 6 und 8 sowie die Brechzahlen n₆ und n₈ der zweiten inneren und äußeren Wellenleiterschicht 6 und 8 nahezu gleich sein.

Die Dicke der Reflexionsschichten 3 und 7 ist so gewählt, daß sie in etwa ein ungeradzahliges Vielfaches von einem Viertel der auf die vertikale Richtung projizierten Wellenlänge der Grundmode ausmacht. Faßt man die Reflexionsschichten jeweils als Fabry-Perot-Kavität auf, entspricht dies einer Antiresonanz der Kavität. Allgemein müssen die Dicken d₃ und d₇ der mittleren Begrenzungsschichten 3 und 7 so gewählt werden, daß die Strahlungsverluste der Grundmode minimal werden, wobei außerdem das Maximum der optischen Intensität der Grundmode entlang der aktiven Schicht 5 verlaufen sollte.

Die Dicken d₂ und d₈ der äußeren Wellenleiterschichten 2 und 8 werden zweckmäßigerweise so gewählt, daß die Strahlungsverluste der Grundmode einen bestimmten Wert nicht übersteigen. Vorzugsweise betragen die Dicken d2 und d8 der äußeren Wellenleiterschichten 2 und 8 ein ungeradzahliges Vielfaches der Hälfte der Dicke des Wellenleiterkerns 11.

Die Wahl der Schichtdicke der Reflexionsschichten 3 und 7 hat zur Folge, daß die Grundmode an den Reflexionsschichten antiresonant reflektiert wird. Die Moden höherer Ordnung hingegen werden resonant reflektiert, so daß diese wesentlich größere Strahlungsverluste erleiden und folglich die Laserschwelle nicht erreichen. Bei optimaler Wahl der Dicke der Reflexionsschichten 3 und 7 lassen sich die Strahlungsverluste der Grundmode auf <1/cm reduzieren, während die Strahlungsverluste höherer Ordnung mehr als 100/cm betragen. Damit können diese Moden die Laserschwelle nicht erreichen.

Anhand von Figur 2 soll nun ein konkretes Ausführungsbeispiel des Halbleiter-Lasers vorgestellt werden. Die folgenden Angaben für die Brechzahlen beziehen sich dabei auf Wellenlänge von 808 nm.

Bei dem Ausführungsbeispiel besteht das Substrat 1 aus n-leitfähigem GaAs mit einer Brechzahl n₁ = 3,67. Die äußeren Wellenleiterschichten 2 und 8 sind aus n-leitendem Al_{0,5}Ga_{0,5}As der Dicke d₂ = d₈ = 1 µm mit einer Brechzahl n₂ = n₈ = 3,29. Die Reflexionsschichten 3 und 7 bestehen aus n-leitendem Al_{0,15}Ga_{0,85}As der Dicke d₃ = d₇ = 0,5 µm mit einer Brechzahl n₃ = n₇ = 3,57. Die inneren Wellenleiterschichten 4 und 6 bestehen aus n-leitendem Al_{0,5}Ga_{0,5}As der Dicke d₄ = d₆ = 1 µm mit einer Brechzahl n₄ = n₆ = 3,29. Für die undotierte, 17 nm dicke aktive Schicht 5 wird schließlich GaAs_{0,5}P_{0,2} mit einer Brechzahl n₅ = 3,61 verwendet.

Figur 3 zeigt den berechneten Verlauf der optischen Intensität der Grundmode 13, wobei der Verlauf des Brechzahlenprofils 12 unterlegt ist. Das in Figur 2 dargestellte Brechzahlenprofil 12 wirkt als antiresonant reflektierender optischer Wellenleiter für die Grundmode 13, wobei die Dicke von 0,5 µm der Reflexionsschichten 3 und 7 ungefähr drei Viertel der in den Wellenleiterkern 11 projizierten Wellenlänge des Laserlichts entspricht. Der Strahlungsverlust der Grundmode 13 beträgt etwa 1/cm.

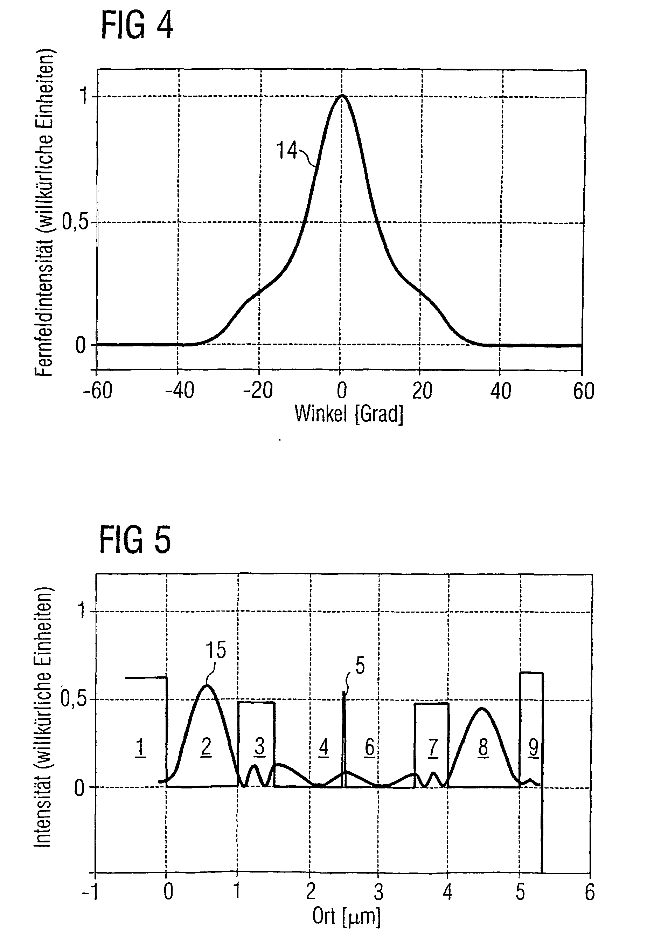

In Figur 4 ist der berechnete Verlauf der Fernfeldintensität 14 der Grundmode 13 dargestellt. Das Diagramm aus Figur 4 zeigt daher die Intensitätsverteilung des Laserstrahls als Funktion des vertikalen Winkels. Die volle Halbwertsbreite des Laserstrahls beträgt 18,6°. Damit beträgt die vertikale Strahldivergenz nur noch etwa die Hälfte der vertikalen Strahldivergenz von herkömmlichen Halbleiter-Lasern.

Figur 5 zeigt den berechneten Verlauf der optischen Intensität einer Mode 5 höherer Ordnung, wobei der Verlauf des Brechzahlenprofils 12 der Darstellung unterlegt ist. Wie an den Intensitätsmaxima in den äußeren Wellenleiterschichten 2 und 8 erkennbar ist, wird die Mode 15 höherer Ordnung an den Reflexionsschichten 3 und 7 nicht antiresonant reflektiert. Durch die Ausdehnung der Mode 15 höherer Ordnung in das Substrat 1 und die Kontaktschicht 9 ist die Mode 15 höherer Ordnung im Vergleich zur Grundmode 13 mit höheren Verlusten behaftet. Die Strahlungsverluste dieser Mode 15 höherer Ordnung betragen 600/cm.

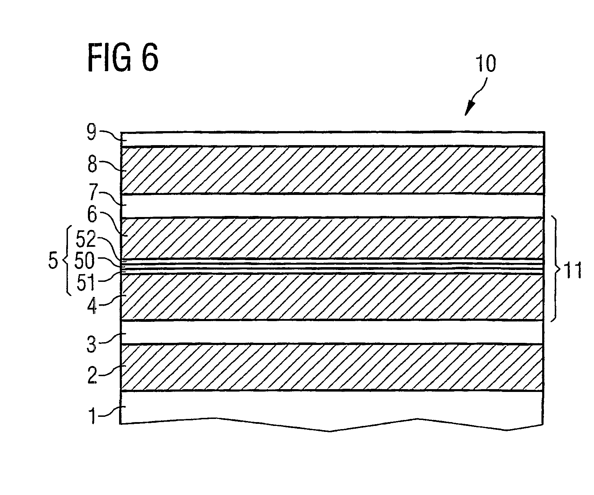

Bei einer anderen Ausführungsform (Figur 6) umfaßt die aktive Schicht 5 zwei sogenannte Spacer-Schichten 51 und 52, zwischen denen ein aktiver Quantentrog 50 angeordnet ist. Eine beispielhafte Schichtenfolge einer solchen Ausführungsform ist in folgender Tabelle aufgezeigt:

| **Schichtart** | **Zusammensetzung** | **Schichtdicke** |
|---|---|---|
| Kontaktschicht | p-GaAs | 300 nm |
| äußere Wellenleiterschicht | p-Al_{0.53}Ga_{0.47}As | 500 nm |
| Reflexionsschicht | p-Al_{0.15}Ga_{0.85}As | 500 nm |
| innere Wellenleiterschicht | p-Al_{0.53}Ga_{0.47}As | 1500 nm |
| Spacer-Schicht | Al_{0.30}Ga_{0.70}As → Al_{0.53}Ga_{0.47}As | 10 nm |
| Aktiver Quantentopf | GaAs_{0.83}P_{0.17} | 17 nm |
| Spacer-Schicht | Al_{0.30}Ga_{0.70}As → Al_{0.53}Ga_{0.47}As | 10 nm |
| innere Wellenleiterschicht | n-Al_{0.53}Ga_{0.47}As | 1500 nm |
| Reflexionsschicht | n-Al_{0.15}Ga_{0.85}As | 500 nm |
| äußere Wellenleiterschicht | n-Al_{0.53}Ga_{0.47}As | 500 nm |
| Substrat | n-GaAs | |

Besonders bevorzugt sind die Reflexionsschichten 3,7 der obigen erfindungsgemäßen Anordnungen hoch dotiert (z.B. 2x10¹⁸ cm⁻³). Dieser Maßnahme liegt für sich alleine schon eine erfinderische Tätigkeit zugrunde. Sie führt die unabhängig von den übrigen erfindungsgemäßen strukturellen Maßnahmen alleine bereits zu verbesserten Leistungsdaten eines Halbleiter-Lasers.

Zur Reduzierung des Bahnwiderstandes können die Heterogrenzen der obigen erfindungsgemäßen Strukturen gradiert sein (graded Heterojunctions).

In den vorliegenden Ausführungsbeispielen besteht die aktive Schicht 5 aus einem zugverspannten GaAsP-Quantenfilm, welcher transversal-magnetisch polarisiertes Licht emittiert. Die aktive Schicht 5 kann allgemein aus einer oder mehreren Quantenfilmen der Zusammensetzung XY bestehen, wobei X wenigstens ein Element aus der Gruppe der Elemente Al, In und Ga und Y wenigstens ein Element aus der Gruppe der Elemente As, P, N und Sb ist. Die aktive Schicht 5 kann weiterhin sowohl unverspannt als auch druckverspannt sein, was zur Emission von transversal-elektrisch polarisiertem Licht führt, oder zugverspannt sein, was die Emission von transversal-magnetisch polarisiertem Licht herbeiführt. Ferner kann die aktive Schicht 5 in Barriereschichten aus dem bereits erwähnten Material XY eingebettet sein. Anstelle von Quantenfilmen können auch Quantendrähte oder Quantenpunkte in die Barriereschichten eingebettet sein.

Ferner sei angemerkt, daß die Ausführungsbeispiele in lateraler Richtung und entlang der Ausbreitungsrichtung des Lichts im Halbleiter-Laser beliebig strukturiert sein können. Dementsprechend kann der durch die vorgestellte Schichtfolge bewerkstelligte antiresonante Wellenleiter 10 sowohl in Breitstreifen-Lasern, Rippenwellenleiter-Lasern, Lasern mit vergrabenen lateralen Wellenleiterstrukturen und Lasern mit verteilter Rückkopplung (distributed feed-back, distributed bragg reflector) verwendet werden. Von Vorteil ist dabei stets die geringe Strahldivergenz in vertikaler Richtung und der große Strahlquerschnitt am Ort der Kristallfacetten.

Die Erläuterung der Erfindung anhand der Ausführungsbeispiele ist selbstverständlich nicht als Einschränkung der Erfindung auf diese zu verstehen. Die Erfindung bezieht sich insbesondere auch auf geeignete andere als die oben genannten Materialsysteme. Darüber hinaus können in den Strukturen neben den explizit beschriebenen Halbleiterschichten weitere ergänzende Halbleiterschichten vorhanden sein.

## Patentansprüche

1. Halbleiter-Laser bei dem
- auf einem Substrat eine Schichtenfolge aufgebracht ist, in der gesehen vom Substrat nacheinander eine erste Wellenleiteraußenschicht (2), eine erste Reflexionsschicht (3), ein Wellenleiterkern (11), in dem eine Photonen emittierende aktive Schicht (5) eingebettet ist, eine zweite Reflexionsschicht (7) und eine zweite Wellenleiteraußenschicht (8) angeordnet sind,
- die erste und die zweite Reflexionsschicht (3, 7) Brechzahlen aufweisen, die größer als die Brechzahlen des Wellenleiterkerns (11) und der jeweils benachbarten Wellenleiteraußenschicht (2, 8) sind,
**dadurch gekennzeichnet, daß**
die Schichtentolge in vertikaler Richtung einen antiresonant reflektierenden Wellenleiter (10) aufweist, wobei die Dicken der Reflexionsschichten (3, 7) so gewählt sind, daß die Grundmode des Halbleiterlasers an den Reflexionsschichten (3, 7) antiresonant reflektiert wird.

2. Halbleiterlaser nach Anspruch 1, bei dem der Wellenleiterkern (11) auf einander gegenüberliegenden Seiten von den beiden Reflexionsschichten (3,7) begrenzt ist.

3. Halbleiterlaser nach Anspruch 1 oder 2, bei dem sich die erste und die zweite Wellenleiteraußenschicht (2,8) jeweils an die nächstliegende der beiden Reflexionsschichten (3,7) anschließt.

4. Halbleiter-Laser nach mindestens einem der vorangehenden Ansprüche, bei dem die Dicke der aktiven Schicht (5) kleiner als die Dicke der angrenzenden Schichten (4, 6) des Wellenleiterkerns (11) ist.

5. Halbleiter-Laser nach mindestens einem der vorangehenden Ansprüche, bei dem die Dicke der Reflexionsschichten (3, 7) gleich einem ungeradzahligen Vielfachen von einem Viertel der in den Wellenleiterkern (11) projizierten Wellenlänge der Photonen sind.

6. Halbleiter-Laser nach mindestens einem der vorangehenden Ansprüche, bei dem die Schichtenfolge hinsichtlich ihrer Dicke bezüglich der aktiven Schicht (5) symmetrisch ist.

7. Halbleiter-Laser nach Anspruch 6, bei dem die Dicke der aktiven Schicht (5) zwischen 0,01 und 0,03 µm, die Dicke des Wellenleiterkerns (11) zwischen 1,5 und 2,5 µm, die Dicken der Reflexionsschichten (3, 7) zwischen 0,4 und 0,6 µm und die Dicken der Wellenleiteraußenschichten (2, 8) zwischen 0,5 und 1,5 µm liegen.

8. Halbleiter-Laser nach mindestens einem der vorangehenden Ansprüche, bei dem eine Brechzahl des Substrates (1) jeweils größer ist als eine Brechzahl der benachbarten Wellenleiteraußenschicht (2) und des Wellenleiterkerns (11).

9. Halbleiter-Laser nach mindestens einem der vorangehenden Ansprüche, bei dem auf die Schichtenfolge eine Kontaktschicht (9) aufgebracht ist, die eine Brechzahl aufweist, die jeweils größer als eine Brechzahl der benachbarten Wellenleiteraußenschicht (8) und des Wellenleiterkerns (11) ist.

10. Halbleiter-Laser nach mindestens einem der vorangehenden Ansprüche, bei dem eine Brechzahl der Wellenleiteraußenschichten (2, 8) gleich einer Brechzahl des Wellenleiterkerns (11) ist.

11. Halbleiter-Laser nach Anspruch 9 oder 10,
bei dem eine Brechzahl des Substrats (1) und der Kontaktschicht (9) jeweils gleich einer Brechzahl der benachbarten Reflexionsschichten (3, 7) ist.

12. Halbleiter-Laser nach mindestens einem der vorangehenden Ansprüche, bei dem die Schichtfolge hinsichtlich der Brechzahlen bezüglich der aktiven Schicht (5) symmetrisch ist.

13. Halbleiter-Laser nach mindestens einem der vorangehenden Ansprüche, bei dem das Substrat (1) und die Schichtfolge zwischen Substrat (1) und aktiver Schicht (5) n-leitend sind.

14. Halbleiter-Laser nach mindestens einem der vorangehenden Ansprüche, bei dem die Kontaktschicht (9) und die Schichtfolge zwischen aktiver Schicht (5) und Kontaktschicht (9) p-leitend sind.

15. Halbleiter-Laser nach mindestens einem der vorangehenden Ansprüche, bei dem das Substrat (1) und die Kontaktschicht (9) aus GaAs hergestellt sind.

16. Halbleiter-Laser nach Anspruch 15,
bei dem die Schichtfolge aus einem Al, Ga und As enthaltenden Halbleiter hergestellt ist.

17. Halbleiter-Laser nach Anspruch 15,
bei dem die Reflexionsschichten (3, 7) aus einem Al, Ga und As enthaltenden Halbleiter und der Wellenleiterkern (11) und die Wellenleiteraußenschichten (2, 8) aus einem In, Ga und P enthaltendem Halbleiter hergestellt sind.

18. Halbleiter-Laser nach mindestens einem der vorangehenden Ansprüche, bei dem die aktive Schicht (5) wenigstens einen in Barriereschichten eingebetteten Quantenfilm aufweist.

19. Halbleiter-Laser nach einem der Ansprüche 1 bis 17,
bei dem die aktive Schicht (5) wenigstens einen in Barriereschichten eingebetteten Quantendraht aufweist.

20. Halbleiter-Laser nach einem der Ansprüche 1 bis 17,
bei dem die aktive Schicht (5) in Barriereschichten eingebettete Quantenpunkte aufweist.

21. Halbleiter-Laser nach mindestens einem der vorangehenden Ansprüche, bei dem die aktive Schicht (5) mit dem Wellenleiterkern (11) identisch ist.

22. Halbleiter-Laser nach mindestens einem der vorangehenden Ansprüche, bei dem die aktive Schicht zwei Spacer-Schichten aufweist, zwischen denen mindestens ein Quantentrog angeordnet ist.

23. Halbleiter-Laser nach Anspruch 22, bei dem die Spacer-Schichten vom Quantentrog zu den nachgeordneten Wellenleiterschichten hin jeweils einen zunehmenden Al-Gehalt aufweisen.

24. Halbleiter-Laser nach mindestens einem der vorangehenden Ansprüche, bei dem die Reflexionsschichten (3,7) hoch dotiert sind.

25. Halbleiter-Laser nach Anspruch 24,
bei dem die Dotierstoffkonzentration in den Reflexionsschichten (3,7) zwischen 5x10¹⁷ und 5x10¹⁹cm⁻³ ist.

## Claims

1. Semiconductor laser in which
- a layer sequence is applied on a substrate, in which layer sequence there are arranged one after the other, as seen from the substrate, a first waveguide outer layer (2), a first reflection layer (3), a waveguide core (11), in which a photon-emitting active layer (5) is embedded, a second reflection layer (7) and a second waveguide outer layer (8),
- the first and second reflection layers (3, 7) have refractive indices which are greater than the refractive indices of the waveguide core (11) and of the respectively adjacent waveguide outer layer (2, 8),
**characterized in that**
the layer sequence has an antiresonant-reflecting waveguide (10) in the vertical direction, the thicknesses of the reflection layers (3, 7) being chosen such that the fundamental mode of the semiconductor laser is reflected in antiresonant fashion at the reflection layers (3, 7).

2. Semiconductor laser according to Claim 1, in which the waveguide core (11) is delimited by the two reflection layers (3, 7) on mutually opposite sides.

3. Semiconductor laser according to Claim 1 or 2, in which the first and second waveguide outer layers (2, 8) respectively adjoin the nearest of the two reflection layers (3, 7).

4. Semiconductor laser according to at least one of the preceding claims, in which the thickness of the active layer (5) is less than the thickness of the adjoining layers (4, 6) of the waveguide core (11).

5. Semiconductor laser according to at least one of the preceding claims, in which the thickness of the reflection layers (3, 7) is equal to an odd-numbered multiple of a quarter of the wavelength of the photons that is projected into the waveguide core (11).

6. Semiconductor laser according to at least one of the preceding claims, in which the layer sequence is symmetrical with respect to the active layer (5) regarding its thickness.

7. Semiconductor laser according to Claim 6, in which the thickness of the active layer (5) lies between 0.01 and 0.03 µm, the thickness of the waveguide core (11) lies between 1.5 and 2.5 µm, the thicknesses of the reflection layers (3, 7) lie between 0.4 and 0.6 µm and the thicknesses of the waveguide outer layers (2, 8) lie between 0.5 and 1.5 µm.

8. Semiconductor laser according to at least one of the preceding claims, in which a refractive index of the substrate (1) is in each case greater than a refractive index of the adjacent waveguide outer layer (2) and of the waveguide core (11).

9. Semiconductor laser according to at least one of the preceding claims, in which a contact layer (9) is applied to the layer sequence, the said contact layer having a refractive index which is in each case greater than a refractive index of the adjacent waveguide outer layer (8) and of the waveguide core (11).

10. Semiconductor laser according to at least one of the preceding claims, in which a refractive index of the waveguide outer layers (2, 8) is equal to a refractive index of the waveguide core (11).

11. Semiconductor laser according to Claim 9 or 10, in which a refractive index of the substrate (1) and of the contact layer (9) is in each case equal to a refractive index of the adjacent reflection layers (3, 7).

12. Semiconductor laser according to at least one of the preceding claims, in which the layer sequence is symmetrical with respect to the active layer (5) regarding the refractive indices.

13. Semiconductor laser according to at least one of the preceding claims, in which the substrate (1) and the layer sequence between substrate (1) and active layer (5) are n-conducting.

14. Semiconductor laser according to at least one of the preceding claims, in which the contact layer (9) and the layer sequence between active layer (5) and contact layer (9) are p-conducting.

15. Semiconductor laser according to at least one of the preceding claims, in which the substrate (1) and the contact layer (9) are produced from GaAs.

16. Semiconductor laser according to Claim 15,
in which the layer sequence is produced from a semiconductor containing Al, Ga and As.

17. Semiconductor laser according to Claim 15,
in which the reflection layers (3, 7) are produced from a semiconductor containing Al, Ga and As and the waveguide core (11) and the waveguide outer layers (2, 8) are produced from a semiconductor containing In, Ga and P.

18. Semiconductor laser according to at least one of the preceding claims, in which the active layer (5) has at least one quantum film embedded in barrier layers.

19. Semiconductor laser according to one of Claims 1 to 17,
in which the active layer (5) has at least one quantum wire embedded in barrier layers.

20. Semiconductor laser according to one of Claims 1 to 17,
in which the active layer (5) has quantum dots embedded in barrier layers.

21. Semiconductor laser according to at least one of the preceding claims, in which the active layer (5) is identical to the waveguide core (11).

22. Semiconductor laser according to at least one of the preceding claims, in which the active layer has two spacer layers between which at least one quantum well is arranged.

23. Semiconductor laser according to Claim 22, in which the spacer layers in each case have an increasing Al content from the quantum well towards the subsequently arranged waveguide layers.

24. Semiconductor laser according to at least one of the preceding claims, in which the reflection layers (3, 7) are highly doped.

25. Semiconductor laser according to Claim 24,
in which the dopant concentration in the reflection layers (3, 7) is between 5 × 10¹⁷ and 5 × 10¹⁹ cm⁻³.

## Revendications

1. Laser à semiconducteur dans lequel,
- il est déposé sur un substrat une succession de couches dans laquelle sont disposés, considéré à partir du substrat, l'une après l'autre une première couche (2) extérieure de guide d'onde, une première couche (3) de réflexion, une âme de guide d'onde dans laquelle est incorporée une couche (5) active émettant des photons, une deuxième couche (7) de réflexion et une deuxième couche (8) extérieure de guide d'onde,
- la première et la deuxième couche (3, 7) de réflexion ont des indices de réfraction qui sont plus grands que les indices de réfraction de l'âme (11) de guide d'onde et de la couche (2, 8) extérieure de guide d'onde respectivement voisine,
**caractérisé en ce que**,
la succession de couches a dans la direction verticale un guide d'onde (10) réfléchissant anti-résonnant, les épaisseurs des couches (3, 7) de réflexion étant choisies de façon à ce que le mode fondamental du laser à semiconducteur soit réfléchi de manière anti-résonnante sur les couches (3, 7) de réflexion.

2. Laser à semiconducteur suivant la revendication 1, dans lequel l'âme (11) du guide d'onde est délimitée sur des faces opposées par les deux couches (3, 7) de réflexion.

3. Laser à semiconducteur suivant la revendication 1 ou 2, dans lequel la première et la deuxième couche (2, 8) extérieure du guide d'onde se raccordent respectivement à la plus proche des deux couches (3, 7) de réflexion.

4. Laser à semiconducteur suivant au moins l'une des revendications précédentes, dans lequel l'épaisseur de la couche (5) active est plus petite que l'épaisseur des couches (4, 6) voisines de l'âme (11) du guide d'onde.

5. Laser à semiconducteur suivant au moins l'une des revendications précédentes, dans lequel les épaisseurs des couches (3, 7) de réflexion sont égales à un multiple impair d'un quart de la longueur d'onde des photons projetés dans l'âme (11) du guide d'onde.

6. Laser à semiconducteur suivant au moins l'une des revendications précédentes, dans lequel la succession de couches est symétrique du point de vue de son épaisseur par rapport à la couche (5) active.

7. Laser à semiconducteur suivant la revendication 6, dans lequel l'épaisseur de la couche (5) active est comprise entre 0,01 et 0,03 µm, l'épaisseur de l'âme (11 ) du guide d'onde est comprise entre 1,5 et 2,5 µm, les épaisseurs des couches (3, 7) de réflexion sont comprises entre 0,4 et 0,6 µm et les épaisseurs des couches (2, 8) extérieures du guide d'onde sont comprises entre 0,5 et 1,5 µm.

8. Laser à semiconducteur suivant au moins l'une des revendications précédentes, dans lequel un indice de réfraction du substrat (1) est respectivement plus grand qu'un indice de réfraction de la couche (2) extérieure voisine du guide d'onde et de l'âme (11) du guide d'onde.

9. Laser à semiconducteur suivant au moins l'une des revendications précédentes, dans lequel il est déposé, sur la succession de couches, une couche (9) de contact, qui a un indice de réfraction qui est plus grand qu'un indice de réfraction de la couche (8) extérieure voisine du guide d'onde et de l'âme (11) du guide d'onde.

10. Laser à semiconducteur suivant au moins l'une des revendications précédentes, dans lequel un indice de réfraction des couches (2, 8) extérieures du guide d'onde est égal à un indice de réfraction de l'âme (11) du guide d'onde.

11. Laser à semiconducteur suivant la revendication 9 ou 10, dans lequel un indice de réfraction du substrat (1) et de la couche (9) de contact est égal respectivement à un indice de réfraction des couches (3, 7) voisines de réflexion.

12. Laser à semiconducteur suivant au moins l'une des revendications précédentes, dans lequel la succession de couches est symétrique du point de vue des indices de réfraction par rapport à la couche (5) active.

13. Laser à semiconducteur suivant au moins l'une des revendications précédentes, dans lequel le substrat (1) et la succession de couches entre le substrat (1) et la couche (5) active sont de conductivité n.

14. Laser à semiconducteur suivant au moins l'une des revendications précédentes, dans lequel la couche (9) de contact et la succession de couches entre la couche (5) active et la couche (9) de contact sont de conductivité du type p.

15. Laser à semiconducteur suivant au moins l'une des revendications précédentes, dans lequel le substrat (1) et la couche (9) de contact sont en GaAs.

16. Laser à semiconducteur suivant la revendication 15, dans lequel la succession de couches est en un semiconducteur contenant de l'Al, du Ga et de l'As.

17. Laser à semiconducteur suivant la revendication 15, dans lequel les couches (3, 7) de réflexion sont en un semiconducteur contenant de l'Al, du Ga et de l'As et l'âme (11) du guide d'onde et les couches (2, 8) extérieures du guide d'onde sont en un semiconducteur contenant de l'In, du Ga et du P.

18. Laser à semiconducteur suivant au moins l'une des revendications précédentes, dans lequel la couche (5) active a au moins un fil quantique incorporé dans des couches formant barrière.

19. Laser à semiconducteur suivant l'une des revendications 1 à 17, dans lequel la couche (5) active a au moins un fil quantique incorporé dans des couches formant barrière.

20. Laser à semiconducteur suivant l'une des revendications 1 à 17, dans lequel la couche (5) active a des points quantiques incorporé dans des couches barrière.

21. Laser à semiconducteur suivant au moins l'une des revendications précédentes, dans lequel la couche (5) active est identique à l'âme (11 ) du guide d'onde.

22. Laser à semiconducteur suivant au moins l'une des revendications précédentes, dans lequel la couche active a deux couches d'espaceur, entre lesquelles est disposé un puits quantique.

23. Laser à semiconducteur suivant la revendication 22, dans lequel les couches d'espaceur ont, du puits quantique aux couches de guide d'onde en aval, respectivement une teneur croissante en Al.

24. Laser à semiconducteur suivant au moins l'une des revendications précédentes, dans lequel les couches (3, 7) de réflexion sont très dopées.

25. Laser à semiconducteur suivant la revendication 24, dans lequel la concentration en substance de dopage des couches (3, 7) de réflexion est comprise entre 5x10¹⁷ et 5x10¹⁹ cm⁻³.
